# EUROPEAN PATENT SPECIFICATION

(11) **EP 1 483 624 B1**
(45) Date of publication and mention of the grant of the patent: **09.07.2008**
(21) Application number: 03714184.3
(22) Date of filing: 14.03.2003
(51) Int. Cl.: G03F 7/115, B41C 1/00, B41C 1/055

(54) **PHOTOSENSITIVE ELEMENT FOR USE AS FLEXOGRAPHIC PRINTING PLATE**
LICHTEMPFINDLICHES ELEMENT ZUR BENUTZUNG ALS FLEXODRUCKPLATTE
ELEMENT PHOTOSENSIBLE SERVANT DE CLICHE D'IMPRESSION FLEXOGRAPHIQUE

(30) Priority: 14.03.2002 US 364956 P
(43) Date of publication of application: 08.12.2004
(73) Proprietor: E.I. DU PONT DE NEMOURS AND COMPANY, Wilmington, Delaware 19898 (US)
(72) Inventor: BODE, Udo, Dietrich, 63303 Dreieich (DE); OSOWSKI, Rudolf, Leonhard, 63303 Dreieich (DE)
(74) Representative: Thomson, James B.
(86) International application number: PCT/US2003/008058
(87) International publication number: WO 2003/079114

(56) References cited:
- EP-A- 0 465 034
- US-A- 5 576 137
- US-A- 5 830 620
- DATABASE WPI Section Ch, Week 199319 Derwent Publications Ltd., London, GB; Class A14, AN 1993-154989 XP002246851 & JP 05 088372 A (FUJI PHOTO FILM CO LTD), 9 April 1993 (1993-04-09)

## Description

### FIELD OF THE INVENTION

This invention pertains to a photosensitive element for use as a flexographic printing plate. Furthermore, the invention pertains to a process for preparing the photosensitive element, a process for preparing a flexographic printing plate from the photosensitive element, and the flexographic printing plate made by that process.

### BACKGROUND OF THE INVENTION

Flexographic printing plates are well known for use in relief printing on a variety of substrates such as paper, corrugated board, films, foils and laminates. Flexographic printing plates can be prepared from photosensitive elements comprising a photopolymerizable layer containing an elastomeric binder, a monomer, and a photoinitiator, interposed between a support and a cover sheet or multilayer cover element. A preferred process of making such photosensitive elements is described in US 4,460,675 where a previously extruded photopolymerizable composition is fed into the nip of a calender and is calendered between a support and a multilayer cover element to form a photopolymerizable layer. Upon imagewise exposure of the photosensitive element with actinic radiation through a photomask, the exposed areas of the photopolymerizable layer are insolubilized. Treatment with a suitable solvent removes the unexposed areas of the photopolymerizable layer leaving a printing relief which can be used for flexographic printing. Such materials are described in US 4,323,637; US 4,427,759; and US 4,894,315.

A common technique for bringing a photosensitive element and a photomask into close contact with one another is to juxtapose the elements and draw a vacuum from between them usually by use of a vacuum frame. When smooth-surfaced elements are brought into such vacuum contact, however, the time required to evacuate air from between the elements and obtain a substantially uniform and complete contact between them becomes exceedingly high. Moreover, even after long periods of time, uniform and complete contact might not be achieved and the photomask may stick so strongly to the photosensitive element that it is damaged when stripped off.

Sometimes, at least one of the photosensitive element or the photomask has a rough outermost layer to avoid these disadvantages. Use of photomasks having rough surfaces are disclosed in US 4,997,735 and US 5,124,227. It is also known to use photosensitive elements with rough outermost layers in combination with photomasks having a smooth surface Several methods are known to provide such rough layers. Cover sheets having a rough layer are stripped off from the photosensitive element, before or after contacting the photomask with the photosensitive element thereby transferring their roughness to the surface of the photosensitive element. Such processes are described in US 5,294,474; US 4,994,344; US 4,957,845; US 4,567,128; US 4,559,292; US 3,891.,443; EP-A 0 549 946; DE-C 26 31 837. Furthermore, it is known to incorporate a small amount of particles into the photosensitive layer itself as disclosed by US 4,599,299; US 4,560,636; US 4,298,678; US 3,891,443; EP-A 0 549 946; EP-A 0 260 943. Such particles can also be incorporated into a temporary protective layer, the so called "release layer", which is a flexible and transparent polymeric film on top of the photosensitive layer and which is removed during development of the imagewise exposed photosensitive elements, as disclosed by US 6,040,116; US 5,593,811; US 5,254,437; US 4,238,560; US 4,072,527; EP-A 0 617 331; DE-A 41 17 127; DE-A 25 12 043; DE-C 21 27 767. It is also known that in addition to the better vacuum contact, a rough outermost layer can also improve the print quality of the final printing plate.

But incorporation of particles into photosensitive layers or release layers often leads to difficulties during development of the imagewise exposed photosensitive elements, for example, sludge deposits in the development processor. Therefore, special materials and processes are used, such as, special polymeric particles having the same composition as the photosensitive layer, and incorporating particles by special process steps, such as spray coating or embossing the surface of the photosensitive element after it has been produced. These techniques are disclosed in US 5,795,647; US 5,576,137; US 5,028,512; US 4,842,982; US 4,557,994; US 4,288,526; EP-A 1 014 194; EP-A 0 649 063; EP-A 0617 331; EP-A 0152 653; DE-C 30 09 928. But these techniques are elaborate because they are restricted to special materials and always require additional process steps.

Therefore, it is an objective of the present invention to provide in an easy and economical way for photosensitive elements to be used with photomasks having a smooth surface. It is another object of the present invention to provide photosensitive elements for preparing flexographic printing plates which show improved printing quality.

### SUMMARY OF THE INVENTION

This objective is solved by a photosensitive element for use as a flexographic printing plate comprising a) a support, b) at least one elastomeric photopolymerizable layer on the support containing at least one elastomeric binder, at least one ethylenically unsaturated compound photopolymerizable by actinic radiation, and at least one photoinitiator or photoinitiator system, and c) a matted layer disposed above a surface of the photopolymerizable layer opposite the support comprising a polymeric binder and at least one matting agent, the at least one matting agent capable of being anchored in the surface of imagewise photopolymerized areas of the photopolymerizable layer during imagewise exposure and development, and selected from the group consisting of i) matting agents having a pore volume of ≥ 0.9 ml/g, ii) matting agents having a BET (Brunauer Emmett Teller) surface of ≥ 150 m²/g, iii) matting agents having an oil number of ≥ 150g/100g, iv) matting agents having at least one crosslinkable group; and v) combinations thereof.

In another embodiment, the invention is directed to a process for preparing the photosensitive element wherein the matted layer is contacted, either by laminating or extrusion followed by calendering, with one surface of the elastomeric photopolymerizable layer.

In a further embodiment, the invention is directed to a process for preparing a flexographic printing plate comprising (A) exposing a photosensitive element to actinic radiation through a photomask forming polymerized areas and unpolymerized areas in the photopolymerizable layer, (B) removing the photomask, and (C) treating the exposed photosensitive element to remove unpolymerized areas and form a relief surface suitable for printing; and a flexographic printing plate made by such a process.

### DETAILED DESCRIPTION OF THE PREFERRED EMBODIMENT(S)

The present invention provides an easy and economical way to prepare a photosensitive element used to make a flexographic printing plate in which the photosensitive element can be used with photomasks having a smooth surface. The present invention also provides for a flexographic printing plate prepared from the photosensitive element showing good ink transfer and printing quality and having enhanced print life. The present invention can be integrated in usual production processes with no additional, special production steps being necessary. It can be adopted for all sorts of flexographic printing plates and various types of flexographic composition. The photosensitive element provides better vacuum contact with the photomask during imagewise exposure than conventional photosensitive elements. Even photomasks having smooth surfaces can be used. Developability of the present photosensitive element is comparable to conventional elements. But the present photosensitive element can have the advantage that no sludge is formed in the processor during development.

A main advantage of the present photosensitive element is that during printing the flexographic printing plate made from this photosensitive element picks up less deposits of paper fibers and dried ink which would fill in reverses areas of the plate. Therefore, high printing quality can be maintained much longer than with former flexographic printing plates and the time between plate cleanings during the printing press run can be extended, resulting in higher productivity.

### Matted layer

The matted layer of the photosensitive element comprises a polymeric binder and at least one matting agent which is capable of being anchored in an outermost surface of the photopolymerizable layer opposite the support. The term "anchored" means that the matting agent remains attached on and/or partially in the outermost surface of imagewise photopolymerized areas of the photopolymerizable layer during imagewise exposure and development as described below, whereas the polymeric binder of the matted layer is removed from the imagewise photopolymerized areas during development. The matting agent is selected from the group consisting of i) matting agents having a pore volume of ≥ 0.9 ml/g, ii) matting agents having a BET surface of ≥ 150 m²/g, iii) matting agents having an oil number of ≥ 150 g/100 g, iv) matting agents having at least one crosslinkable group; and v) combinations thereof.

The pore volume of the matting agent under i) is determined by titration with water. The test sample is activated by heating for 2 hours at 200 °C. 10-40 g of the test sample are weighed into a screw top jar. Sufficient water is added from a burette to fill about 80 % of the expected pore volume. The jar is then vigorously shaken to distribute the water evenly throughout the sample. The sample is cooled to room temperature under cold water and further small additions of water are made until a saturated gel has formed, which adheres to the base of the jar when inverted. At this point the water has filled all of the pores and begins to cover the external surface of the sample. After each addition the jar is shaken vigorously. The pore volume is calculated by: pore volume (ml/g) = quantity of water added (ml)/ weight of sample (g). Preferably, a matting agent with a pore volume of 1.0-2.5 ml/g is used. Especially matting agents with a pore volume of 1.5-2.5 ml/g are suitable.

BET surface means the specific surface determined according to the method of Brunauer, Emmett, and Teller (see also DIN 66131). By this method, the volume of nitrogen gas is measured, which is adsorbed on the surface of the adsorbing material at -196 °C dependent upon the applied pressure. This method is well known to those skilled in the art. Preferably, a matting agent with a BET surface of ≥ 200 m²/g is used. Especially matting agents with a BET surface of ≥ 280 m²/g are suitable.

The oil number is measured according to DIN ISO 787-5 (ASTM D 281). The oil number represents the amount of oil in g necessary to process 100 g' of a pigment (here the matting agent) to form an adhering cementlike mass. Preferably, a matting agent with an oil number of ≥ 200 g/100 g is used. Especially matting agents with an oil number of ≥ 250 g/100 g are suitable.

The term "crosslinkable group" for matting agents having at least one crosslinkable group of iv) is intended to encompass photopolymerizable and photocrosslinkable groups as well as such groups which are thermally crosslinkable. Preferred crosslinkable groups are ethylenically unsaturated groups, such as, e.g., vinyl groups, acryloyl groups or methacryloyl groups, and epoxy groups. Especially preferred are ethylenically unsaturated groups. Matting agents comprising such crosslinkable groups are prepared by conventional surface modification of silicic acids or silica matting agents with silanes comprising the crosslinkable group and an alkoxy group or halogen atom. Such surface modifications are described in DE-A 33 25 064 and DE-B 23 04 602.

Preferably, the matting agent has a mean particle size of ≥ 3 µm. The mean particle size is the particle size determined according to ASTM-D 4438-85 (Coulter Counter method). Especially suitable are matting agents having a mean particle size of 3-15 µm. Preferably, ≥60% by volume of the total particles of the matting agent are between 3 to 15 µm; especially preferred are ≥ 80 % by volume. The matting agent may include ≤ 20 % by volume of particles with a particle size of ≥ 15 µm. Such particles are useful to provide roughness to the surface of the photosensitive element after peel-off of the cover sheet resulting in reduced vacuum draw-down time and easier lift-off of the photomask after exposure. Furthermore, the matting agent may comprise ≥ 10 %, preferably 10-30 %, by volume of particles with a particle size of ≤ 3 µm, and preferably 5-15 % of ≤ 2 µm. Particles with a particle size of ≤ 3 µm may advantageously enhance the surface coverage of the flexographic printing plate with matting agent, whereby the print quality of such flexographic printing plate can be further improved due to the enhanced hydrophilicity of the printing plate surface. Such printing plates are especially useful for polar printing inks containing water, alcohols, and/or other polar compounds. Especially, these printing plates can provide the further advantage of forming a barrier layer on top of the surface resulting in less penetration of ink solvent components thereby lowering the swelling of the printing plates and providing higher surface hardness for longer print runs.

It is advantageous to use a matting agent having a combination of the particle characteristics described for i), ii), iii), and/or iv). A matting agent having a mean particle size of ≥ 3 µm, a pore volume of ≥ 0.9 ml/g, and an oil number of ≥ 150 g/100 g is suitable, and further including a BET surface of ≥ 150 m²/g is particularly suitable. Most suitable are those matting agents having a mean particle size of ≥ 3 µm, a pore volume of 1.0-2.5 ml/g, an oil number of ≥ 200 g/100 g, and a BET surface of ≥ 200 m²/g.

Preferably, the matting agent has a refractive index similar to that of the other components of the photosensitive element.

The matting agent may be any inorganic or organic matting agent having one or more of the above described properties. Preferably, the matting agent is selected from the group consisting of silicas, silicic acids, silicates, like clays, kaolinites, zeolithes, then aluminas and/or aluminates, and mixtures thereof.

It is also possible to use a matting agent that is filled and/or loaded with at least one ethylenically unsaturated compound photopolymerizable by actinic radiation. Suitable monomers are those which are used in the photopolymerizable layer and which are disclosed below. Preferably, polar monomers with good adsorption to the surface of the matting particles, especially such with low viscosity and high diffusion capability in the photopolymerizable layer, can be used, for example, hexamethylene glycol diacrylate and/or hexamethylene glycol dimethacrylate. By the use of matting agents filled and/or loaded with monomers it is possible to reduce the ageing time of the photosensitive elements after their production which is necessary to equilibrate the photopolymerizable layer to achieve suitable sensitometric characteristics and to equilibrate the photopolymerizable layer and the matted layer for purpose of monomer migration from the photopolymerizable layer into the matted layer, especially into the pores and/or onto the surface of the matting agent. This migration of monomers seems to provide anchoring of the matting agent during imagewise exposure of the photosensitive element. Another possibility to reduce the ageing time is to apply heat to the photosensitive element instead of ageing at ambient temperature. Longer ageing time and/or ageing at higher temperatures may provide better anchoring of the matting agent. But not in all embodiments of the invention, it seems to be necessary to have a good anchoring of the matting agent for improved printing quality.

Preferably, the matting agent is present in an amount of ≥ 10 % by weight of the matted layer, preferably ≥ 15 % by weight, and most preferably 15-20 % by weight. The matting agent may be used in an amount up to 60 % by weight of the matted layer. Furthermore, the matting agent may include ≤ 20 % by weight of other particulate materials not capable of being anchored in the surface of the photopolymerizable layer, such as, for example, polymer beads, etc.

It is preferred that the matted layer and the photopolymerized printing plate have special surface roughness. Surface roughness, as described herein, is measured with a Hommeltester by profile measurement. The surface roughness Rz according to DIN 4768 of the matted layer alone, i.e., before association with the photopolymerizable layer, is preferably ≥ 3 µm, especially ≥ 5 µm. The surface roughness Rz of the photosensitive element after removal of a cover sheet is preferably ≥ 2 µm, especially ≥ 2.5 µm. The roughness Rz of the printing surface of the flexographic printing plate after treating, and optionally after-treatment, is preferably ≥ 2.5 µm, especially ≥ 3 µm.

In addition to the matting agent, the matted layer comprises a polymeric binder. Suitable polymers are soluble or strippable or removable during treating of the photosensitive element. Such are, for example, polyamides as nylon and nylon copolymers, polyvinyl alcohols, polyurethanes, polyvinyl pyrrolidones, polyethylene oxides of Mw ≥ 100,000, copolymers of ethylene and vinyl acetate, cellulose ester, cellulose ether. It is especially preferred to use polyamides. Usually, the polymeric binder is present in an amount of ≤ 85 % by weight of the matted layer. Preferably, the matted layer comprises 40-90 % by weight of the polymeric binder.

Optionally, the matted layer may comprise colorants, e.g., dyes and/or pigments as well as photochromic additives, i.e., for identification or for better contrast between imaged and non-imaged areas of the photosensitive elements directly after imagewise exposure or after imagewise exposure and development. In one embodiment of the invention, a dye can provide enhanced exposure latitude to the photosensitive element. Exposure latitude means the fill-in of reverse depths due to light scattering. This is especially important for print quality and good reproduction of fine elements. These colorants must not interfere with the imagewise exposure of the photopolymerizable layer. Suitable colorants are, e.g., soluble acridine dyes, anthraquinone dyes, phenazine dyes, and phenoxazine dyes, such as, for example, methylene violet (C.I. Basic Violet 5), methylene blue B (C.I. 52015), Solvent Black 3 (C.I.26150), Rhodamin 3 GO (C.I. Basic Red 4), Solvent Blue 11 (C.I. 61525), Victoria Pure Blue BO (C.I. Basic Blue 7 or C.I. 42595), anthraquinone Blue 2 GA (C.I. Acid Blue 58), Safranin T (C.I. 50240), etc. Usually; the colorant is present in an amount of 0.0001-2 % by weight of the matted layer. Preferably, the matted layer comprises 0.001-1 % by weight of the colorant

The matted layer may optionally form an integrated masking layer for the photosensitive element. As such, the matted layer becomes an infrared (IR) sensitive layer, which means that the matted layer can be imaged with an infrared laser radiation. Therefore, the matted layer can contain material having high infrared absorption in the wavelength range between 750 and 20,000 nm, such as, for example, polysubstituted phthalocyanine compounds, cyanine dyes, merocyanine dyes, etc., inorganic pigments, such as, for example, carbon black, graphite, chromium dioxide, etc., or metals, such as aluminum, copper, etc. The quantity of infrared absorbing material is usually 0.1-40 % by weight, relative to the total weight of the layer. Furthermore, the matted layer in this embodiment is opaque to ultraviolet or visible light, that is, has an optical density ≥ 2.5. To achieve this optical density, the matted layer contains a material that prevents the transmission of actinic radiation. This actinic radiation blocking material can be the same or different than the infrared absorbing material, and can be for example, dyes or pigments, and in particular the aforesaid inorganic pigments. The quantity of the radiation blocking material is usually 1-70 % by weight relative to the total weight of the layer. When the matted layer is IR-sensitive, it may include as the polymeric binder, for example, nitrocellulose, homopolymers or copolymers of acrylates, methacrylates and styrenes, polyamides, polyvinyl alcohols, etc. All these compounds are described in detail, for example in WO 94/03838 and WO 94/3839 which disclose IR-sensitive layers as integrated photomasks for flexographic printing plates. Other auxiliary agents, such as plasticizers, coating aids, waxes, surfactants, etc. can be included in the matted layer. Preferably, waxes with a softening temperature ≥ 70 °C, especially polyethylene waxes having a softening temperature ≥ 90 °C, can be used.

Conventional methods like slot coating, roll coating, gravure coating, or spray coating are used to prepare the matted layer from a solution or dispersion of the components in suitable solvents. The matted layer is applied on the cover sheet, and subsequently dried. The thickness of the matted layer is usually 0.02-40 µm, preferably 0.05-20 µm, especially 0.5-10 µm with a usual dry coating weight of 0.01-10 g/m², preferably 0.1-5 g/m². The dry coating weight of the matting agent usually is 0.001-5 g/m², preferably 0.01-2 g/m².

### Photopolymerizable layer

The photopolymerizable layer of the photosensitive element for use as flexographic printing plate consist of known photopolymerizable materials. As used herein, the term "photopolymerizable" is intended to encompass systems which are photopolymerizable, photocrosslinkable, or both. All photopolymerizable materials of the state of the art can be used. Especially preferred are the materials disclosed in US 4,323,637; US 4,427,759; and US 4,894,315. They usually comprise at least one elastomeric binder, at least one photopolymerizable, ethylenically unsaturated monomer, and at least one photoinitiator or photoinitiator system, wherein the photoinitiator is sensitive to actinic radiation, which usually includes ultraviolet radiation and/or visible radiation.

Examples of elastomeric binders are polyalkadienes, alkadiene/acrylonitrile copolymers; ethylene/propylene/alkadiene copolymers; ethylenel(meth)acrylic acid((meth)acrylate copolymers; and thermoplastic, elastomeric block copolymers of styrene, butadiene, and/or isoprene. Linear and radial thermoplastic, elastomeric block copolymers of styrene and butadiene and/or isoprene are preferred. Preferably, the binder is present in an amount of ≥ 65 % by weight of the photopolymerizable material.

Monomers that can be used in the photopolymerizable layer are well known in the art and include ethylenically unsaturated, copolymerizable, organic compounds, such as, for example, acrylates and methacrylates of monovalent or polyvalent alcohols; (meth)acrylamides; vinyl ethers and vinyl esters; etc., in particular acrylic and/or methacrylic of butanediol, hexanediol, diethylene glykol, trimethylol propane, pentaerythritol, etc.; and mixtures of such compounds. Preferably, the monomer is present in an amount of ≥ 5 % by weight of the photopolymerizable material.

Suitable photoinitiators are individual photoinitiators or photoinitiator systems, such as, for example, benzoin derivatives, benzil acetals, diarylphosphine oxides, etc., also mixed with triphenyl phosphine, tertiary amines, etc. Preferably, the photoinitiator is present in an amount of 0.001-10.0 % by weight of the photopolymerizable material

In addition to the main components described in the foregoing, the photopolymerizable compositions may comprise conventional additives like, for example, W absorbers, thermal stabilizers, plasticizers, colorants, antioxidants, fillers, etc.

The thickness of the photopolymerizable layer can vary over a wide range depending upon the type of flexographic printing plate desired. For so called "thin plates" the photopolymerizable layer can be from about 0.05-0.17 cm in thickness. Thicker plates will have a photopolymerizable layer up to 0.25-0.64 cm in thickness or greater.

### Support

The support can be any flexible material which is conventionally used with photosensitive elements for use as flexographic printing plates. Examples for suitable support materials include polymeric films such those formed by addition polymers and linear condensation polymers, transparent foams and fabrics, and metals such as aluminum. A preferred support is a polyester film; particularly preferred is polyethylene terephthalate. The support typically has a thickness from 0.001-0.030 inch (0.025- 0.762 mm).

### Cover sheet

The photosensitive element optionally comprises a cover sheet as outermost protective layer on top of the matted layer or if present on top of the IR-sensitive layer. Useful cover sheets consist of flexible polymeric films, e.g., polyethylene terephthalate, which preferably is unsubbed but optionally may be subcoated with a thin silicone layer, polystyrene, polyethylene, polypropylene, or other strippable polymeric films. Preferably, polyethylene terephthalate is used.

### Additional layers

Additional layers may be present on top of the photopolymerizable layer. Suitable layers are those disclosed as elastomeric layers in the multilayer cover element described in US 4,427,759 and US 4,460,675. Such elastomeric layers comprise layers which are insensitive to actinic radiation themselves but become photosensitive when contacted with the photopolymerizable layer as well as such layers which are photosensitive themselves. These photosensitive elastomeric layers comprise preferably an elastomeric binder, a monomer, and a photoinitiator, and optionally fillers or other additives. Elastomeric layers which become photosensitive when contacted with the photopolymerizable layer do not comprise any monomer. Binder, monomer, and other compounds can be the same or similar to those compounds comprised in the photopolymerizable layer. These elastomeric layers are disposed between the photopolymerizable layer and the matted layer.

The photosensitive element can optionally include a wax layer as disclosed in DE-C 199 09 152 between the matted layer and the photopolymerizable layer, or between the matted layer and the elastomeric layer if present. Suitable waxes are all natural and synthetic waxes, such as polyolefin waxes, paraffin waxes, carnauba waxes, stearin waxes, and steramide waxes. Preferred are waxes with a softening temperature ≥ 70 °C, especially polyethylene waxes having a softening temperature ≥ 90 °C. Conventional methods like casting, printing, or spray coating are used to prepare the wax layers from dispersions of the waxes in suitable solvents. The wax layer is usually 0.02-1.0 µm thick, preferably 0.05-0.5 µm.

Furthermore, the photosensitive element may optionally comprise an IR-sensitive layer on top of the matted layer. The IR-sensitive layer can form an integrated masking layer for the photosensitive element. The preferred IR-sensitive layer is removable during treating, i.e., soluble or dispersible in a developer solution or removable during thermal development; opaque to actinic radiation, i.e., ultraviolet or visible light, that is, has an optical density ≥ 2.5; and can be imaged with an infrared laser. The IR sensitive layer contains material having high infrared absorption in the wavelength range between 750 and 20,000 nm, such as, for example, polysubstituted phthalocyanine compounds, cyanine dyes, merocyanine dyes, etc., inorganic pigments, such as, for example, carbon black, graphite, chromium dioxide, etc., or metals, such as aluminum, copper, etc. The quantity of infrared absorbing material is usually 0.1-40 % by weight, relative to the total weight of the layer. To achieve the optical density of ≥ 2.5 to block actinic radiation, the infrared-sensitive layer contains a material that prevents the transmission of actinic radiation. This actinic radiation blocking material can be the same or different than the infrared absorbing material, and can be, for example, dyes or pigments, and in particular the aforesaid inorganic pigments. The quantity of this material is usually 1-70 % by weight relative to the total weight of the layer. The infrared-sensitive layer optionally includes a polymeric binder, such as, for example, nitrocellulose, homopolymers or copolymers of acrylates, methacrylates and styrenes, polyamides, polyvinyl alcohols, etc. Other auxiliary agents, such as plasticizers, coating aids, etc. are possible. The infrared-sensitive layer is usually prepared by coating or printing a solution or dispersion of the aforesaid components on the cover sheet, and subsequently drying it before the matted layer is applied onto the cover sheet. The thickness of the infrared-sensitive layer is usually 2 nm to 50 µm, preferably 4 nm to 40 µm. These infrared-sensitive layers and their preparation are described in detail, for example in WO 94/03838 and WO 94/3839.

The photosensitive element can optionally include an adhesive layer between the support and the photopolymerizable layer. Such adhesive materials are disclosed in US 3,036,913 or US 2,760,863. Alternatively, the support can have an adhesion promoting surface by flame-treatment or electron-treatment or the adhesion of the photopolymerizable layer to the support can be enhanced by exposure to actinic radiation through the support.

Furthermore, the photosensitive element can optionally include an antihalation layer between the support and the photopolymerizable layer. Such antihalation layer can be made by dispersing a finely divided dye or pigment which substantially absorbs actinic radiation in a solution or aqueous dispersion of a resin or polymer which is adherent to both the support and the photopolymerizable layer and coating it on the support and drying. Suitable antihalation pigments and dyes include carbon black, manganese dioxide, Acid Blue Black (Cl 20470), and Acid Magenta O (Cl 42685). Suitable polymeric or resin carriers include polyvinyl compounds, e.g., polyvinyl chloride homo- and copolymers, copolymers of acrylic and methacrylic acid.

### Process for preparing photosensitive elements

The present photosensitive element can be prepared by contacting the matted layer with one surface of a photopolymerizable layer. In one instance, the matted layer, is disposed on a cover sheet, and is then laminated onto the outermost surface of the element opposite the support, which is typically the photopolymerizable layer, with a conventional laminator. The photopolymerizable layer itself may be prepared in many ways by admixing the binder, monomer, initiator, and other ingredients and forming it into a sheet layer. It is preferred that the application of the matted layer onto the photopolymerizable layer is integrated within the usual production process of photosensitive elements for use as flexographic printing plates. Generally, the photopolymerizable mixture is formed into a hot melt and then calendered to the desired thickness. An extruder can be used to perform the function of melting, mixing, deaerating and filtering the composition. The extruded mixture is then calendered between the support and a cover element. Concerning the present invention, this cover element comprises a cover sheet, optionally an IR-sensitive layer, the matted layer, and optionally a wax layer and/or an elastomeric layer. Alternatively, the photopolymerizable material can be placed between the support and the cover element in a mold. The layers of material are then pressed flat by the application of heat and/or pressure. The combination of extrusion/calendering process is particularly preferred. The better the contact between the matted layer and the photopolymerizable layer, the better seems to be the anchoring of matting agent to the surface of the photopolymerized layer later on. After the photosensitive element is prepared, it is cooled, e.g., with blown air, and is passed under a bank of fluorescent lamps, e.g., black light tubes, placed traverse to the path of movement. The photosensitive element is continually exposed through the support to partially polymerize a predetermined thickness of the photopolymer layer adjacent the support.

### Process for preparing flexographic printing plates

The photosensitive element produced as described above is then imagewise exposed by common processes through a photomask having areas transparent to actinic radiation and areas substantially opaque to actinic radiation. Actinic radiation means ultraviolet and visible radiation. The photomask can be a separate film, i.e., an image-bearing transparency or phototool, such as a silver halide film; or can be the photomask integrated with the photosensitive element as described above. In the case in which the photomask is a separate film, the optional cover sheet is usually stripped before imagewise exposure leaving the matted layer on the photosensitive element. The photomask is brought into close contact with the matted layer of the photosensitive element by the usual vacuum processes, e.g., by use of a common vacuum frame. Thus a substantially uniform and complete contact between the matted layer and the photomask can be achieved in acceptable time. By applying vacuum, the atmospheric oxygen is removed and the effect of oxygen inhibiting polymerization is minimized. The absence of atmospheric oxygen may furthermore lead to better anchoring of the matting agent.

In the case in which there is a IR-sensitive layer on the matted layer or the matted layer also functions as the IR-sensitive layer, the IR-sensitive layer is imagewise exposed to IR laser radiation to form the photomask on the photosensitive element. The infrared laser exposure can be carried out using various types of infrared lasers, which emit in the range 750 to 20,000 nm. Infrared lasers including, diode lasers emitting in the range 780 to 2,000 nm and Nd:YAG lasers emitting at 1064 nm are preferred. The radiation opaque layer is exposed imagewise to infrared laser radiation to form the image on or disposed above the photopolymerizable layer, i.e., the in-situ mask. The infrared laser radiation can selectively remove, e.g., ablate or vaporize, the infrared sensitive layer (i.e., radiation opaque layer) from the photopolymerizable layer, as disclosed by Fan in U.S. Patents 5,262,275 and 5,719,009; and Fan in EP 0 741 330 B1. The integrated photomask remains on the photosensitive element for subsequent steps of overall exposure to actinic radiation and treating. For photosensitive elements having the integrated photomask, the imagewise exposure may be conducted in the presence or absence of atmospheric oxygen. However, it is preferred that the imagewise exposure is conducted in the absence of atmospheric oxygen, for example, under vacuum, to minimize the effect of oxygen inhibiting polymerization whereby also better anchoring of the matting agent may be achieved.

Upon imagewise exposure, the radiation-exposed areas of the photopolymerizable layer are converted to the insoluble state with no significant polymerization or crosslinking taking place in the unexposed areas of the layer. Any conventional source of actinic radiation can be used for this exposure. Examples of suitable radiation sources include xenon lamps, mercury vapor lamps, carbon arcs, argon glow lamps, fluorescent lamps with fluorescent materials emitting UV radiation and electron flash units, and photographic flood lamps. The most suitable sources of UV radiation are the mercury vapor lamps, particularly the sun lamps. The exposure time may vary from a few seconds to minutes, depending upon the intensity and spectral energy distribution of the radiation, its distance from the photosensitive element, and the nature and amount of the photopolymerizable material. A long exposure time may improve the anchoring of the matting agent on the surface of the flexographic printing plate and thereby enhance the surface coverage by the matting agent. An overall back exposure may be conducted before or after the imagewise exposure to polymerize a predetermined thickness of the photopolymer layer adjacent the support. This polymerized portion of the photopolymer layer is designated a floor. The floor thickness varies with the time of exposure, exposure source, etc. This exposure may be done diffuse or directed. All radiation sources suitable for imagewise exposure may be used. The exposure is generally for 1-30 minutes.

Following overall exposure to UV radiation through the mask, the photosensitive printing element is treated to remove unpolymerized areas in the photopolymerizable layer and thereby form a relief image. The treating step removes at least the photopolymerizable layer in the areas which were not exposed to actinic radiation, i.e., the unexposed areas or uncured areas, of the photopolymerizable layer. The matted layer disposed above the non-exposed areas of the photopolymerizable layer and the polymeric binder of the matted layer which are disposed above the exposed areas of the photopolymerizable layer are removed with the treating step.

After the photopolymerizable layer has been polymerized by exposure and the relief formed by treatment, the surface opposite the support ultimately is the printing surface of the printing element. The printing surface is the raised area/s of the relief which carry ink. This printing surface of the photopolymerized printing plate may be covered with particles of the matting agent from the matted layer. Surface coverage, as herein described is measured under a microscope in transmission orby SEM/EDX techniques as described below. In one embodiment of the invention, ≥ 0.5 % of the printing surface of the flexographic printing plate is covered with the matting agent, preferably, 0.5-1 % of the printing surface. In another embodiment of the invention, ≥ 1 % of the printing surface of the flexographic printing plate is covered with the matting agent, preferably, ≥ 2 % of the printing surface. In a further embodiment of the invention, ≥ 10 % of the printing surface of the flexographic printing plate is covered with the matting agent, preferably, ≥ 20 % of the printing surface. In a further embodiment of the invention, 20-30 % of the printing surface can be covered with the matting agent. For special applications, it may be especially advantageous when ≥ 30 % of the surface of the flexographic printing plate are covered with the matting agent. Flexographic printing plates showing a high covering of the printing surface with matting agent can advantageously be used in offset lacquering applications.

Except for the elastomeric capping layer, typically the additional layers that may be present on the photopolymerizable layer are removed or substantially removed from the polymerized areas of the photopolymerizable layer. For photosensitive elements including a separate IR-sensitive layer for digital formation of the mask, the treating step also removes the mask image (which had been exposed to actinic radiation).

Treatment of the photosensitive printing element includes (1) "wet" development wherein the photopolymerizable layer is contacted with a suitable developer solution to washout unpolymerized areas and (2) "dry" development wherein the photosensitive element is heated to a development temperature which causes the unpolymerized areas of the photopolymerizable layer to melt or soften or flow and is wicked away by contact with an absorbent material. Dry development may also be called thermal development.

Wet development is usually carried out at about room temperature. The developers can be organic solvents, aqueous or semi-aqueous solutions, or water. The choice of the developer will depend primarily on the chemical nature of the photopolymerizable material to be removed. Suitable organic solvent developers include aromatic or aliphatic hydrocarbon, and aliphatic or aromatic halohydrocarbon solvents, for example, n-hexane, petrol ether, hydrated petrol oils, limonene or other terpenes or toluene, isopropyl benzene, etc., ketones such as methyl ethyl ketone, halogenated hydrocarbons such as chloroform, trichloroethane, or tetrachloroethylene, esters such as acetic acid or acetoacetic acid esters, or mixtures of such solvents with suitable alcohols. Other organic solvent developers have been disclosed in published German Application 38 28 551. Suitable semi-aqueous developers usually contain water and a water miscible organic solvent and an alkaline material. Suitable aqueous developers usually contain water and an alkaline material. Other suitable aqueous developer combinations are described in U.S. Patent No. 3,796,602. Additives such as surfactants or alcohols may be used.

Development time can vary, but it is preferably in the range of about 2 to about 25 minutes. Developer can be applied in any convenient manner, including immersion, spraying and brush or roller application. Brushing aids can be used to remove the unpolymerized portions of the element. Washout can be carried out in an automatic processing unit which uses developer and mechanical brushing action to remove the unexposed portions of the plate, leaving a relief constituting the exposed image and the floor.

Following treatment by developing in solution, the relief printing plates are generally blotted or wiped dry, and then more fully dried in a forced air or infrared oven. Drying times and temperatures may vary, however, typically the plate is dried for 60 to 200 minutes at 60 °C. High temperatures are not recommended because the support can shrink and this can cause registration problems.

Treating the element thermally includes heating the photosensitive element having at least one photopolymerizable layer (and the additional layer/s) to a temperature sufficient to cause the uncured portions of the photopolymerizable layer to soften or melt or flow, and contacting an outermost surface of the element to an absorbent surface to absorb or wick away the melt or flow portions. The polymerized areas of the photopolymerizable layer have a higher melting temperature than the unpolymerized areas and therefore do not melt, soften, or flow at the thermal development temperatures. Thermal development of photosensitive elements to form flexographic printing plates is described by Martens in U.S. Patents 5,015,556; 5,175,072; 5,215,859; and by Wang et al. in WO 98/13730.

The term "melt" is used to describe the behavior of the unirradiated portions of the photopolymerizable elastomeric layer subjected to an elevated temperature that softens and reduces the viscosity to permit flow and absorption by the absorbent material. The material of the meltable portion of the photopolymerizable layer is usually a viscoelastic material which does not have a sharp transition between a solid and a liquid, so the process functions to absorb the heated composition layer at any temperature above some threshold for absorption in the absorbent material. A wide temperature range may be utilized to "melt" the composition layer for the purposes of this invention. Absorption may be slower at lower temperatures and faster at higher temperatures during successful operation of the process.

The thermal treating steps of heating the photosensitive element and contacting an outermost surface of the element with an absorbent material can be done at the same time, or in sequence provided that the uncured portions of the photopolymerizable layer are still soft or in a melt state when contacted with the absorbent material. The at least one photopolymerizable layer (and the additional layer/s) are heated by conduction, convection, radiation, or other heating methods to a temperature sufficient to effect melting of the uncured portions but not so high as to effect distortion of the cured portions of the layer. The one or more additional layers disposed above the photopolymerizable layer may soften or melt or flow and be absorbed as well by the absorbent material. The photosensitive element is heated to a surface temperature above about 40 °C, preferably from about 40 °C to about 230 °C (104-446 °F) in order to effect melting or flowing of the uncured portions of the photopolymerizable layer. By maintaining more or less intimate contact of the absorbent material with the photopolymerizable layer that is molten in the uncured regions, a transfer of the uncured photosensitive material from the photopolymerizable layer to the absorbent material takes place. While still in the heated condition, the absorbent material is separated from the cured photopolymerizable layer in contact with the support layer to reveal the relief structure. A cycle of the steps of heating the photopolymerizable layer and contacting the molten (portions) layer with an absorbent material can be repeated as many times as necessary to adequately remove the uncured material and create sufficient relief depth. However, it is desirable to minimize the number of cycles for suitable system performance, and typically the photopolymerizable element is thermally treated for 5 to 15 cycles. Intimate contact of the absorbent material to the photopolymerizable layer (while in the uncured portions are melt) may be maintained by the pressing the layer and the absorbent material together.

A preferred apparatus to thermally develop the photosensitive element is disclosed by Peterson et al. in U.S. Patent 5,279,697, and also by Johnson et al. in Patent Cooperation Treaty Application No. PCT/US00/24400 filed September 6, 2000 (IM-1289 PCT). The photosensitive element may be placed on a drum or a planar surface in order for thermal treatment to be carried out.

The absorbent material is selected having a melt temperature exceeding the melt temperature of the uncured portions of the photopolymerizable layer and having good tear resistance at the same operating temperatures. Preferably, the selected material withstands the temperatures required to process the photosensitive element during heating. The absorbent material is selected from non-woven materials, paper stocks, fibrous woven material, open-celled foam materials, porous materials that contain more or less a substantial fraction of their included volume as void volume. The absorbent material can be in web or sheet form. The absorbent materials should also possess a high absorbency for the molten elastomeric composition as measured by the grams of elastomer that can be absorbed per square millimeter, of the absorbent material. Preferred is a non-woven nylon web.

It is also contemplated that the photosensitive element may undergo one or more treating steps to sufficiently remove the uncured portions to form the relief. The photosensitive element may undergo both wet development and dry development, in any order, to form the relief. A pre-development treating step may be necessary to remove one or more of the additional layers disposed above the photopolymerizable layer if such additional layers are not removable by the washout solution and/or by heating.

The flexographic printing plate may be post exposed and/or chemically or physically after-treated in any sequence to detackify the surface of the flexographic printing plate.

### EXAMPLES

The following examples illustrate the invention, but do not limit it. Unless otherwise indicated, the parts and percentages indicated refer to the weight.

In the following examples, CYREL^{®} flexographic printing plates (including plates identified herein as DuPont types, HOS, NOW, HiQ), CYREL^{®} exposure unit, CYREL^{®} processor, Cyrel^{®} mounting tape, and CYREL^{®} Flexosol^{®} washout solvent are products sold by E. I. du, Pont de Nemours and Company, Wilmington, DE.

### SEM/EDX Evaluation of Flexoplate Surfaces

For confirming silica particles anchored on the plate surface Scanning Electron Microscope (SEM) techniques were used in combination with Energy Dispersive X-ray (EDX) spectrometry. The surfaces of the samples were vacuum-sputtered with a thin gold film of some few Angstroem to ensure a sufficient surface conductivity, which is needed fir the SEM/EDX evaluation. For the surface analysis a SEM Type Zeiss DSM 962 (from Carl Zeiss Company, now Leo Elektronenmikroskopie GmbH, Carl-Zeiss Str. 56, D-7344 Oberkochen/Germany) equipped with Secondary-Electrons (SE)- and Back-Scattered Electrons (BSE)-detectors and with an EDX spectrometer Type Noran Vantage (from THERMO NORAN, 2551 W.Beltline Hwy., Middleton, WI 53562, USA) for element analysis and element mapping option was used. The images were taken at magnification of 50x, 100x, 200x for studying surface areas in the range of about 0.5-5 mm². By moving the sample in XY-direction by microdrives, larger areas of about 5 cm x 5 cm (areas of about 5 cm² up to 25 cm²) were evaluated and inspected for structure uniformity.

Higher magnifications were used to evaluate details of the surface pattern and of particles anchored on the sample surface. At magnifications of 500x and 1000x the surface was evaluated for finer details and finer surface structures. The SEM images and the correlating EDX mapping images were taken at 200x and 500x. In addition, the BSE mode of the microscope was used for higher element contrasting, so that particles anchored at the surface could be easier recognized.

By scanning sections of the surface area and simultaneous recording of the X-ray signals an element spectrum was obtained. Single particles were analyzed separately to confirm Si from the silica particles dispersed into the release layer and bonded to the plate surface. Element distribution was recorded for Si (silica) and the images were further analyzed to determine the silica surface coverage on the different plate samples. Only particles containing Silicium were found. On all plates tested, Si was found, however, at different Si levels corresponding with different levels of silica coverage,-depending on photopolymer type and plate preparation or manufacturing conditions.

The BSE mode provided a good contrast for the silica particles which can be seen as bright areas due to the larger amount of back-scattered electrons from Si versus the surrounding matrix of organic photopolymer material. High contrast images were also obtained with EDX mapping; mapping run typically for about 8 hours and allowed to detect small silica particles of 1-2 µm diameter difficult to recognize with other methods.

High contrast images from BSE and EDX mapping were further analyzed using the image analysis software analySIS^{®} Pro Version 3.00 from Soft Imaging Systems GmbH, Johann-Krane-Weg 39, D-48149 Münster, Germany. The images were filtered to remove the noise level, and contrasted; from the EDX images a binary element distribution image was obtained from which the Si surface coverage was determined. Beside Si only the elements C, O, and Au from the gold sputtering were found: consequently, the Si detected correlated directly with silica particles anchored on the plate surface.

### Example 1

7.00 % of a polyamide (Macromelt^{®} 6900, from Henkel KGaA, D-40191, Düsseldorf, Germany) were dissolved in a solvent blend of n-propanol, toluene, and cyclohexane (17.50 %/27.50 %/45.00 %). A matting agent/polymeric binder ratio of 30/70 was adjusted by adding 3.00 % of a highly porous, highly polar and hydrophilic silica gel (Syloid^{®} ED-5 from GRACE GmbH & Co. KG, D-67545 Worms, Germany, having a pore volume of 1.8 ml/g; oil number of 320 g/100 g; a BET surface of 380 m²/g; mean particle size of 5 µm (D50 = 9.44 µm, measured with Mastersizer 2000 from Malvern Instruments/UK), particle size distribution of > 80 % by volume within 2.5-15 µm). The matting agent was dispersed with glass beads having a diameter of 2 mm for 5 min on a disperser (BAS-20 from Lau GmbH, D-58675, Germany) with a vibration frequency of 620 min⁻¹ according to DIN 53238-13 (draft ISO 8780). The dispersion was coated with a 30 µm doctor-box on a polyester cover sheet to form a matted layer. After air drying at ambient room conditions (22 °C, 45% relative humidity) the resulting dry matted layer had a measured total coating weight of 27.50 mg/dm² and a corresponding calculated coating weight of the matting agent of 8.25 mg/dm².

The so produced cover element was hot laminated to a Cyrel^{®} 1 OOHOS flexoplate to produce a photosensitive element with the matted layer contacting the photopolymerizable layer of the Cyrel^{®} plate: The original cover sheet and release layer of the Cyrel^{®} plate had been peeled-off before lamination. Lamination was carried out by a hot stamping press at 120 °C and with a lamination holding time of 10 sec at a pressure of 1 bar. After accelerated aging for 2 hours at 70 °C in a hot oven, the photosensitive, element was back exposed in a Cyrel^{®} Exposure Unit 1001 E for 25 sec to form a floor of 0.7 mm. The cover sheet was peeled off whereby the matted layer remained on the photopolymerizable layer. The matted layer of the photosensitive element was covered with a glossy phototool and the photosensitive element was imagewise-exposed under vacuum for 10 min in a Cyrel^{®} Exposure Unit 1001 E. The vacuum draw-down time was 3 min. After imagewise-exposure, the glossy phototool could be easily taken off and the element was developed in a Cyrel^{®} Processor 1002 P with Flexosol^{®} at 32 °C for 400 sec. The resulting printing plate was dried at 60°C for 3 hours in a Cyrel^{®} Dryer 1002 D and simultaneously finished by UV-A and UV-C exposure in a Cyrel^{®} Light Finisher 1002 LF for 6 min.

The surface roughness Rmax, Rz and Ra of the dry matted layer before lamination to the Cyrel^{®}plate was measured with a surface profile tester T20-DC/RP50 (from-Hommelwerke GmbH, D-78056 Villingen- Schwenningen, Germany) according to DIN 4768 (Rmax), DIN 4768 (Rz) and DIN 4762/DIN 4768/ISO 4287/1 (Ra). Filtering (R profil), selection of the cut-off length (0.8 mm) and selection of the total measuring length (4 mm) was adjusted according to DIN 4768/IS0 4288. The surface roughness Rmax was 9.2 µm, Rz was 8.4 µm and Ra was 1.5 µm measured on top of the dry matted layer before lamination to the Cyrel^{®}plate. In a similar way the surface roughness of the photosensitive element after cover sheet peel-off and before exposure was measured. The following data were obtained: for Rmax 3.25 µm, for Rz 2.63 µm and for Ra 0.35 µm. Then the photosensitive element was back and front exposed, washed-out, dried and finished. After processing the press-ready printing plate was measured again and the following surface roughness data were measured: for Rmax 4.85 µm, for Rz 4.10 µm and for Ra 0.40 µm. Furthermore, the processed plate was evaluated under the microscope in transmission and it was found that more than 20% of the surface was covered with matting agent particles.

### Example 2

As described in Example 1, a cover element with a matted layer was produced wherein the matted layer was prepared from a coating dispersion containing 5.00 % of Macromelt^{®} 6900 and 5.00 % of Syloid^{®} ED-5. The resulting dry matted layer had a measured total coating weight of 31.5 mg/dm² and a calculated matting agent/polymeric binder ratio of 50/50. A photosensitive element comprising this cover element was prepared and processed as described in Example 1. After processing more than 30 % of the printing plate surface were covered with matting agent.

### Example 3

Example 1 was repeated with a coating dispersion comprising 6.93 % Macromelt^{®} 6900, 2.97 % Syloid^{®} EDS, 19:64 % n-propanol, 27.89 % of toluene, and 41.25 % cyclohexane. Additionally, 1.32 % hexamethylene glycol diacrylate were added to the dispersion to fill and/or load the matting agent with monomer. The resulting dry matted layer had a total coating weight of 30.8 mg/dm². A photosensitive element comprising this cover element was prepared and processed as described in Example 1. After processing more than 20 % of the printing plate surface were covered with matting agent.

### Example 4

A 100 µm thick polyester film was coated on one side with a matted layer consisting of 70 % by weight of a polyamide (Macromelt^{®} 6900, from Henkel Corp.) and 30 % by weight of a porous silica (Syloid^{®} ED-5 from Grace & Co., having a pore volume of 1.8 ml/g; oil number of 320 g/100 g; a BET surface of 380 m²/g; mean particle size of 5 µm (D50 = 9.44 µm. measured with Mastersizer 2000 from Malvem Instruments/UK), particle size distribution of > 80 % by volume within 2.5-15 µm), the matted layer having a dry coating weight of 3,4 g/m². This matted layer was overcoated with a polyethylene wax layer. In the standard manufacturing process of DuPont Cyrel^{®} 45HiQ and 67HiQ photopolymerizable printing plates, this cover element according to the present invention was used as cover element instead of the conventional cover element. As comparative examples DuPont Cyrel^{®} 45HiQ and 67HiQ photopolymerizable printing plates with standard cover element (polyester cover sheet with release layer comprising Macromelt^{®} 6900 and an amphoteric interpolymer) were produced, too. In the manufacturing process, an extruder was used to perform the function of melting, mixing, deaerating and filtering the conventional photopolymerizable mixture for Cyrel^{®} HiQ photopolymer printing plates. This mixture was extruded through a flat die between a polyester base film and the cover element with the matted layer in contact with the photopolymerizable layer. The material was calendered to the required Cyrel^{®} photopolymer plate thickness, cooled down to room temperature and cut into plates.

According to the standard procedures for the production of flexographic printing plates from photosensitive elements, as described in Example 1, the inventive and standard photopolymerizable plates were imagewise exposed through a photographic film containing a test target for flexographic printing plate performance evaluation and processed in a standard DuPont Cyrel^{®} processing unit using DuPont Flexosol^{®} as the processing solution. Then the plates were dried for 3 hours at 60°C in an dryer for flexographic printing plates and finished by exposing with UV-light in a standard UV-finishing unit. Surprisingly the surface of the inventive plates was not tacky after drying for 20 minutes in a dryer at 60°C, while the standard plates exhibited the usual tackiness. Evaluations of the photosensitivity of standard and inventive plates showed no differences in the maximum allowable exposure time.

Inventive and conventional printing plates were printed on a Lemo Masterflex^{®} flexographic printing machine using a 500er anilox with a ink volume of 3;5 cm³/m² at a print speed of 120 meters per minute. For the print trials, paper (Sappi Algro Finess; 70 g/m²) and film (Trespaphan^{®} SHD 50.0) were used in combination with solvent based ink for film (LM magenta from Siegwerk Druckfarben/Siegburg) and water based ink for paper (Hartmann Magenta). In both cases the inventive printing plates improved the quality of the print compared to the standard printing plates. Especially, an improved reproduction of the middle tone to shadow areas was achieved.

### Example 5

A photosensitive element based on Cyrel^{®} 67NOW was prepared according to Example 4, wherein the standard release layer was replaced by a release layer comprising Syloid^{®} ED5 and Macromelt^{®} 6900 as described in Example 4 and having a matting agent/polymeric binder ratio of 17/83. The photosensitive element was processed to a flexographic printing plate as described in Example 4. The final printing plate was evaluated with the previously described SEM/EDX techniques. A silica surface coverage of 2-5 % was determined. The surface appeared matte. The roughness was measured as described in Example 1 and the following data were found: Rmax = 4.90 µm, Rz = 3.85 µm, and Ra = 6.60 µm. As a comparative example a commercial Cyrel^{®} 67NOW plate was processed in the same way. The surface of the press-ready plate was highly glossy. The roughness was measured as follows: Rmax = 2.80 µm, Rz = 2.35 µm and Ra = 0.35 µm.

### Example 6

Two photosensitive elements based on Cyrel^{®} 67HiQ were prepared according to Example 4, wherein the standard release layer was replaced by a release layer comprising Syloid^{®} ED5 and Macromelt^{®} 6900 as described in Example 4 and having a matting agent/polymeric binder ratio of 17/83. Before the photosensitive elements were processed to flexographic printing plates as described in Example 4, one element was stored at ambient temperature for 1 month (Plate A), whereas the other element was stored at 70 °C in a hot oven for 3 days (Plate B). The final printing plates were evaluated with the previously described SEM/EDX techniques. Plate A showed a silica surface coverage of 0.5-1 %, and Plate B showed a silica surface coverage of 1-3 %.

### Example 7

A photosensitive element based on Cyrel^{®} 67HiQ was prepared according to the process described in Example 1. The matted layer comprised Syloid^{®} ED5 and Macromelt^{®} 6900 as described in Example 1 and had a matting agent/polymeric binder ratio of 25/75 and a silica coating weight of 5.2 mg/dm². Before the photosensitive element was processed to a flexographic printing plate as described in Example 4 (but without a finishing step), the element was stored at 100 °C in a hot oven for 16 h. The final printing plate was evaluated with the previously described SEM/EDX techniques. A silica surface coverage of 26 % was determined.

### Example 8

A printing test was performed with 2 sets of flexographic printing plates for printing on PE-film and paper and for comparing the print performance of the following plate types:
- Sample 1: Cyrel^{®} 67HiQ - with standard release layer;
- Sample 2: HiQ-NS - a Cyrel^{®} 67HiQ plate with a matted layer instead of the standard release layer;
- Sample 3: BASF 67ACE - with standard release layer.

The photopolymerizable plate of Sample 2 was prepared according to Example 4, except that the matting agent/polymeric binder ratio of the matted layer was adjusted to 17/83.

Two sets of printing plates were prepared by standard procedure as described in Example 1 and Example 4. Exposure conditions for backflash were 65 sec and 70 sec, respectively, and for main exposure 18 min and 15 min, respectively. The plates were exposed in a Cyrel^{®} Exposure Unit 1000 EC/LF and washed-out in a Cyrel^{®} Processor Smart 1000 P with Cyrel^{®} Flexosol as wash-out solvent. The plates were dried in a Cyrel^{®}Dryer 1002 D for 3 h at 60 °C. Light finishing and post exposure was done in a Cyrel^{®} Lightfinisher 1002 LF for 3 min with UV-A and UV-C radiation simultaneously.

After the processing was completed Sample 2 showed a matte surface different from Sample 1 which had a glossy surface. The surface roughness was measured according to Example 1. The following roughness data were measured: for Sample 1 Rmax = 3.00 µm, Rz = 2.55 µm, and Ra = 0.43 µm; for Sample 2 Rmax = 6.10 µm, Rz = 4.93 µm, and Ra = 0.78 µm, for Sample 3 Rmax = 1.93 µm, Rz = 2.33 µm, and Ra = 0.35 µm. All plates were similar in hardness, between 68 and 70 Shore A.

These printing plates were tested in separate print runs. The first set of plates was printed on PE-film with a solvent based ink (Type ZPEA 2 HOKO RA from Siegwerk Druckfarben, Siegburg). The second set was printed on paper with a water based ink (Type TP RW from Hartmann).

Inventive and conventional printing plates were printed on a Lemo Masterflex^{®} flexographic printing machine at a speed of 120 m/min. The printing impression on film was adjusted to 120 µm and for printing on paper to 180 µm. The anilox rolls were Type Praxair with 320 Ucm at 60° with a cell volume of 4 cm³/m². The anilox impression was set to 60 µm. The substructure of the plate was a GFK sleeve (no. 40) with mounting tape Cyrel^{®} MONT 2038: The trials were printed on coated paper (SAPPI; 5302 ALGRO-FINESSI70 g/m²) and on PE-film (Type PE 55 µm; white opaque coloured; pre-treated with a 1350 W adjustment). The ambient temperature and humidity conditions were measured as 25 °C and 43 - 52 % relative humidity during the print run.

The print results on PE-film are listed in Table 1, and the print results on paper are listed in Table 2. The test prints were evaluated by using common techniques familiar to those skilled in the art, i.e. measurement of optical densites and dot gain on a Gretag D 19C reflection densitometer (GretagMacbeth, Little Windsor NY). The evaluation is based on a screen ruling of 54 U cm. Overall best results were achieved for Sample 2. Sample 2 performed with lowest dot gain and highest solid densities on both PE-film and paper. Sample 3 gave poor solid densities on paper. Sample 2 was best in ink uniformity and ink lay-down in the solid areas compared to Sample 1 and Sample 3.

**Table 1**

| tonal value film [%] | Sample 1 | Sample 2 | Sample 3 |
|---|---|---|---|
| 100 | 1.60 | 1.71 | 1.57 |
| | Tonal value on print [%] | | |
| 90 | 101 | 100 | 101 |
| 80 | 100 | 99 | 100 |
| 70 | 98 | 97 | 99 |
| 60 | 96 | 94 | 97 |
| 50 | 94 | 92 | 94 |
| 40 | 91 | 88 | 92 |
| 30 | 85 | 79 | 84 |
| 20 | 73 | 67 | 72 |
| 10 | 60 | 53 | 58 |
| 5 | 44 | 36 | 39 |
| 4 | 39 | 33 | 38 |
| 3 | 34 | 31 | 31 |
| 2 | 28 | 28 | 24 |
| 1 | 24...27 | 21...24 | 22...25 |

**Table 2**

| tonal value film [%] | Sample 1 | Sample 2 | Sample 3 |
|---|---|---|---|
| 100 | 1.24 | 1.30 | 1.20 |
| | Tonal value on print [%] | | |
| 90 | 99 | 99 | 100 |
| 80 | 98 | 95 | 99 |
| 70 | 93 | 89 | 95 |
| 60 | 90 | 84 | 91 |
| 50 | 84 | 77 | 85 |
| 40 | 75 | 71 | 81 |
| 30 | 68 | 61 | 70 |
| 20 | 52 | 47 | 56 |
| 10 | 37 | 32 | 39 |
| 5 | 24 | 21 | 26 |
| 4 | 22 | 18 | 24 |
| 3 | 20 | 15 | 23 |
| 2 | 17 | 13 | 19 |
| 1 | 15 | 11 | 16 |

### Example 9

Two photosensitive elements based on Cyrel^{®} 67HiQ were prepared and processed as described in Example 4. In one element (Sample 1), the standard release layer was replaced by a matted layer comprising 17.25 % of weight of Syloid^{®} ED5 as described in Example 4, 76.5 % of weight of the Macromelt^{®} 6900, and 6.25 % of weight of a blue dye (Orasol Blue GL from Ciba Specialty Chemicals Inc., CH-4002 Basel, Switzerland), the total coating weight was 32 mg/ dm², the silica coating weight was 5.5 mg/ dm². In the second element (Sample 2), the standard release layer was replaced by a matted layer comprising Syloid^{®} ED5 and Macromelt^{®} 6900 as described in Example 4 and having a matting agent/polymeric binder ratio of 17/83.

The surface roughnesses Rz of the matted layers were 10.03 (Sample 1) and 9.48 (Sample 2). The surface roughnesses Rz of the final flexographic printing plates were 3.99 (Sample 1) and 3.98 (Sample 2).

The element with the blue dyed matted layer (Sample 1) had a significant higher exposure latitude than the element with the non-dyed matted layer. That means, even on longer exposure times, the fill-in of the reverses due to light scattering was very low for Sample 1 compared to Sample 2. At an exposure time of 15 min, Sample 2 had already lost about 31 % more reverse depth than Sample 1. The reverse fill-in after 5 min additional exposure time was only 4 % loss for Sample 1 versus 2x more (9 %) for Sample 2. The dye-free element had a much faster fill-in, especially when exposure time was further increased. The loss of reverse depth after increased exposure to 35 min of exposure time was only 11 % for Sample 1 versus 32 % compared to Sample 2, which was 3x better than Sample 2. In summary, Sample 1 showed only minor loss of reverse depth at longer exposure times, which is important for printing of fine elements to maintain a high resolution. These results were confirmed by printing test.

**Table 3**

| Reverse Depth [µm] and % loss of 0.8 mm line versus exposure [min] | | | | | | |
|---|---|---|---|---|---|---|
| | | | | | | |
| | Sample 1 | | | Sample 2 | | |
| | | | | | | |
| [min] | [µm] | % | % loss | [µm | % | % loss |
| 15 | 441 | 100 | | 306 | 100 | |
| 20 | 424 | 96 | 4 | 277 | 91 | 9 |
| 25 | 413 | 94 | 6 | 254 | 83 | 17 |
| 30 | 424 | 96 | 4 | 233 | 76 | 24 |
| 35 | 391 | 89 | 11 | 208 | 68 | 32 |

### Example 10

Three flexographic printing plates were prepared according to the process described in Example 4,
a) HiQ-NS-A was a flexo plate based on a Cyrel^{®} 67HiQ plate wherein the standard release layer was replaced by a matted layer comprising Syloid^{®} ED5 and Macromelt^{®} 6900 and having a matting agent/polymeric binder ratio of 17/83 and a silica coating weight of 5.5 mg/ dm²;
b) HiQ-NS-B was a flexo plate based on a Cyrel^{®} 67HiQ plate wherein the standard release layer was replaced by a matted layer comprising 17.25 % of weight of Syloid^{®} ED5, 76.5 % of weight of the Macromelt^{®} 6900, and 6.25 % of weight of a blue dye (Orasol Blue GL from Ciba Specialty Chemicals Inc., CH-4002 Basel, Switzerland), the total coating weight was 32 mg/ dm², the silica coating weight was 5.5 mg/ dm²;
c) HiQ-NS-C was a flexo plate based on a Cyrel^{®} 67HiQ plate wherein the standard release layer was replaced by a matted layer comprising Syloid^{®} ED5 and Macromelt^{®} 6900, and having a matting agent/polymeric binder ratio of 30/70 and a silica coating weight of 9.6 mg/ dm².

These printing plates were compared with a commercially available Cyrel^{®} 67HiQ printing plate comprising a standard release layer (polyester cover sheet with release layer comprising Macromelt^{®} 6900 and an amphoteric interpolymer), (HiQ in Table 4).

The surface roughness Rz of the flexographic printing plates was measured as described in Example 1.

Also ink spreading and ink wettability performance of these flexographic printing plates were determined by evaluation with test inks of different surface tension. A set of test inks from Arcotec GmbH, Rotweg 24, D-71297 Moensheim/Germany was used. The lower number of surface tension represents the test ink which wetted the plate surface; the higher number of surface tension represents the test ink which showed de-wetting on plate surface. The higher the surface tensions the better the wetting of the flexographic printing plate with polar printing inks.

**Table 4**

| Plate Type | Release Layer | Plate Surface | Surface Tension |
|---|---|---|---|
| | | Rz[µm] | [mN/m] |
| | | | |
| HiQ | Standard | 1.06 | 32 - 35 |
| HiQ-NS-A | ED5; 17/83 | 3.98 | 35 - 38 |
| HiQ-NS-B | NS-A + Dye | 3.99 | 35 - 38 |
| HiQ-NS-C | ED5; 30/70 | 4.63 | 44 - 48 |

### Example 11

Macromelt^{®} 6900 (3.90 weight %) was dissolved in a solvent blend of i-propanol (47.00 weight %) and toluene (47 weight %). Then Aerosil^{®} 200 (Degussa AG, Weissfrauenstr. 9, D-602287 Frankfurt/Main, Germany) (0.90 %) was added and dispersed for 30 min in a disperser as described in Example 1 to achieve a good dispersion, then Syloid^{®} ED5 (1.20 weight %) was added and dispersed for additional 5 min. A dispersion of Aerosil^{®} 200 and Syloid^{®} ED5 was obtained and coated on a Mylar^{®} 100A polyester film and treated as described in Example 1. This cover element was laminated to a Cyrel^{®} 67HiQ printing plate instead of the standard cover element under the conditions described in Example 1. After storage for 16 h at 100 °C, UV exposure, wash-out and drying as described in Example 1, the final printing plate was evaluated with the previously described SEM/EDX techniques. A silica surface coverage of 15.9 % was determined.

By the addition of Aerosil^{®} 200 the coating viscosity of the coating dispersion could be increased. This allowed to coat a much lower dry coating weight than without Aerosil^{®} addition. The dry coating weight of this example could be reduced by reducing the solids from 8 % to 6 % without jeopardizing the coatability. The coatability was maintained and very good coating uniformity was observed. No drying structures of the coating even with longer drying times were seen. The coating weight could be reduced from 32 mg/dm² to 24 mg/ dm². The flexographic printing plate resulting from this cover element (sample plate) gave equivalent physical properties compared to a Cyrel^{®}67HiQ printing plate with a matted layer without Aerosil^{®} 200 (Sample 2 of Example 9, here: reference plate). The surface roughness of the sample plate was found to be slightly lower (Rz = 3.25 µm), but still close and equivalent to the reference plate (Rz = 3.98 µm).

## Claims

1. A photosensitive element for use as a flexographic printing plate comprising
a) a support,
b) at least one elastomeric photopolymerizable layer on the support containing at least one elastomeric binder, at least one ethylenically unsaturated compound photopolymerizable by actinic radiation, and at least one photoinitiator or photoinitiator system, and
c) a matted layer disposed above a surface of the photopolymerizable layer opposite the support comprising a polymeric binder and at least one matting agent, the at least one matting agent capable of being anchored in the surface of imagewise photopolymerized areas of the photopolymerizable layer during imagewise exposure and development, and selected from the group consisting of
i) matting agents having a pore volume of ≥ 0.9 ml/g;
ii) matting agents having a BET (Brunauer Emmett Teller) surface of ≥ 150 m²/g;
iii) matting agents having an oil number of ≥ 150g/100g;
iv) matting agents having at least one crosslinkable group; and
v) combinations thereof.

2. The photosensitive element of Claim 1 wherein the matting agent is capable of being anchored during contacting the matted layer to the photopolymerizable layer and exposing the photosensitive element to actinic radiation.

3. The photosensitive element of Claim 1 wherein the matted layer comprises ≥ 10 % by weight of the matting agent.

4. The photosensitive element of Claim 1 wherein the matted layer comprises ≥ 15 % by weight of the matting agent.

5. The photosensitive element of Claim 1 wherein the matting agent has a pore volume of 1.0-2.5 ml/g.

6. The photosensitive element of Claim 1 wherein the matting agent has a BET surface of ≥ 200 m²/g.

7. The photosensitive element of Claim 1 wherein the matting agent has an oil number of ≥ 200 g/100 g.

8. The photosensitive element of Claim 1 wherein the matting agent is filled and/or loaded with at least one ethylenically unsaturated compound photopolymerizable by actinic radiation.

9. The photosensitive element of Claim 1 wherein the matting agent having at least one crosslinkable group contains at least one ethylenically unsaturated group photopolymerizable by actinic radiation.

10. The photosensitive element of Claim 1 wherein the matting agent having at least one crosslinkable group is capable of being anchored thermally.

11. The photosensitive element of Claim 1 wherein the matting agent is a matting agent with a mean particle size of ≥ 3 µm.

12. The photosensitive element of Claim 1 wherein the matting agent is a matting agent with a mean particle size of 3-15 µm.

13. The photosensitive element of Claim 1 wherein the matting agent is a matting agent with a mean particle size of ≥ 3 µm, a pore volume of ≥ 0.9 ml/g, and oil number of ≥ 150 g/100 g.

14. The photosensitive element of Claim 1 wherein the matting agent is a matting agent with a mean particle size of ≥ 3 µm, a pore volume of ≥ 0.9 ml/g, oil number of ≥ 150 g/100 g, and a BET surface of ≥ 150 m²/g.

15. The photosensitive element of Claim 1 wherein the matting agent is a matting agent with a mean particle size of ≥ 3 µm, a pore volume of 1.0-2.5 ml/g, oil number of ≥ 200 g/100 g, and a BET surface of ≥ 200 m²/g.

16. The photosensitive element of Claim 1 wherein the matting agent comprises ≤ 20 % by weight of particles with a particle size of ≥ 15 µm, the weight percentage based on the total amount of matting agent.

17. The photosensitive element of Claim 1 wherein the matting agent comprises ≥ 10 % by weight of a matting agent with a particle size of ≤ 3 µm, the weight percentage based on the total amount of matting agent.

18. The photosensitive element of Claim 1 wherein the matting agent comprises ≤ 20 % by weight of a matting agent not capable of being anchored in the surface of the photopolymerizable layer.

19. The photosensitive element of Claim 1 wherein the matted layer comprises at least one matting agent selected from the group consisting of silicic acids, silicates, and/or aluminates.

20. The photosensitive element of Claim 1 wherein the matted layer comprises at least one polymeric binder selected from the group consisting of polyamides, copolymers of ethylene and vinyl acetate, polyesters, cellulose esters, and polyolefins.

21. The photosensitive element of Claim 1 wherein the matted layer comprises at least one pigment and/or dye.

22. The photosensitive element of Claim 1 wherein the matted layer comprises at least one IR-sensitive compound.

23. The photosensitive element of Claim 1 further comprising an additional layer between the matted layer and the elastomeric photopolymerizable layer, the additional layer selected from the group consisting of an elastomeric layer capable of becoming photosensitive, and a wax layer.

24. The photosensitive element of Claim 1 further comprising a cover sheet on the matted layer opposite the photopolymerizable layer.

25. The photosensitive element of Claim 1 further comprising an IR-sensitive layer disposed above the matted layer opposite the photopolymerizable layer.

26. A process for preparing a photosensitive element comprising
(a) providing an elastomeric photopolymerizable layer disposed on a support wherein the photopolymerizable layer contains at least one elastomeric binder, at least one ethylenically unsaturated compound photopolymerizable by actinic radiation, and at least one photoinitiator or photoinitiator system, the elastomeric photopolymerizable layer having a surface opposite the support;
(b) providing a matted layer comprising a polymeric binder and at least one matting agent, the at least one matting agent capable of being anchored in the surface of imagewise photopolymerized areas of the photopolymerizable layer during imagewise exposure and development, and selected from the group consisting of
i) matting agents having a pore volume of ≥ 0.9 ml/g;
ii) matting agents having a BET (Brunauer Emmett Teller) surface of ≥ 150 m²/g ;
iii) matting agents having an oil number of ≥ 150g/100g;
iv) matting agents having at least one crosslinkable group; and
v) combinations thereof,
and
(c) contacting the matted layer with the surface of the elastomeric photopolymerizable layer forming the photosensitive element.

27. The process of Claim 26 wherein the photosensitive element further comprises an additional layer between the matted layer and the elastomeric photopolymerizable layer, the additional layer selected from the group consisting of an elastomeric layer capable of becoming photosensitive, and a wax layer, the process further comprising:
providing the additional layer to the element by either
(d')providing the additional layer on the surface of the elastomeric photopolymerizable layer, and contacting the matted layer to a surface of the additional layer opposite the elastomeric photopolymerizable layer, or
(d") providing the additional layer on the matted layer and contacting the additional layer to the surface of the elastomeric photopolymerizable layer.

28. The process of Claim 26 wherein contacting is by laminating the matted layer on the surface of the photopolymerizable layer opposite the support.

29. The process of Claim 26 wherein contacting comprises:
(1) passing into the nip of a calender a mass of a hot photopolymerizable composition comprising at least one elastomeric polymer, at least one ethylenically unsaturated compound photopolymerizable by actinic radiation, and at least one photoinitiator or photoinitiator system, and
(2) while hot, calendering the photopolymerizable composition between the support and a cover element to form the photopolymerizable layer therebetween, wherein the cover element comprises a cover sheet and the matted layer, the matted layer being adjacent to the photopolymerizable layer.

30. A process for preparing a flexographic printing plate comprising
(A) exposing to actinic radiation through a photomask a photosensitive element comprising
a) a support,
b) at least one elastomeric photopolymerizable layer on the support containing at least one elastomeric binder, at least one ethylenically unsaturated compound photopolymerizable by actinic radiation, and at least one photoinitiator or photoinitiator system, and
c) a matted layer disposed above a surface of the photopolymerizable layer opposite the support comprising a polymeric binder and at least one matting agent, the at least one matting agent capable of being anchored in the surface of imagewise photopolymerized areas of the photopolymerizable layer during imagewise exposure and development, and selected from the group consisting of
i) matting agents having a pore volume of ≥ 0.9 ml/g
ii) matting agents having a BET (Brumauer Emmett Teller) surface of ≥ 150 m²/g
iii) matting agents having an oil number of ≥ 150g/100g;
iv) matting agents having at least one crosslinkable group; and
v) combinations thereof,
forming polymerized areas and unpolymerized areas in the photopolymerizable layer;
(B) removing the photomask,
(C) treating the exposed photosensitive element to remove unpolymerized areas and form a relief surface suitable for printing.

31. The process of Claim 30 wherein the treating step (C) is selected from the group consisting of
(1) developing with at least one washout solution selected from the group consisting of solvent solution, aqueous solution, semi-aqueous solution, and water; and
(2) heating the element to a temperature sufficient to cause the unpolymerized portions to melt, flow, or soften, and contacting the element with an absorbent material to remove the unpolymerized portions.

32. The process of Claim 30 wherein the exposing step (A) occurs in a vacuum.

33. The process of Claim 30 wherein the exposing step (A) occurs in the absence of atmospheric oxygen.

34. The process of Claim 30 wherein the removing step (B) occurs during the treating step (C).

35. The photosensitive element of Claim 2 wherein the exposure occurs in a vacuum.

36. A flexographic printing plate produced by the process of Claim 30.

37. The flexographic printing plate of Claim 36 wherein the surface of the flexographic printing plate comprises particles of the matting agent.

38. The flexographic printing plate of Claim 36 wherein ≥ 0.5 % of the surface of the flexographic printing plate are covered with the matting agent.

39. The flexographic printing plate of Claim 36 wherein ≥ 1 % of the surface of the flexographic printing plate are covered with the matting agent.

40. The flexographic printing plate of Claim 36 wherein ≥ 10 % of the surface of the flexographic printing plate are covered with the matting agent.

## Patentansprüche

1. Photoempfindliches Element zur Benutzung als Flexodruckplatte, umfassend:
a) einen Träger,
b) mindestens eine elastomere photopolymerisierbare Schicht auf dem Träger, enthaltend mindestens ein elastomeres Bindemittel, mindestens eine ethylenisch ungesättigte Verbindung, die durch aktinische Strahlung photopolymerisierbar ist, und mindestens einen Photoinitiator oder ein Photoinitiatorsystem und
c) eine mattierte Schicht, die sich über einer Oberfläche der photopolymerisierbaren Schicht dem Träger gegenüberliegend befindet, umfassend ein polymeres Bindemittel und mindestens ein Mattierungsmittel, wobei das mindestens eine Mattierungsmittel in der Lage ist in der Oberfläche der bildmäßig photopolymerisierten Bereiche der photopolymcrisicrbareix Schicht während des bildmäßigen Aussetzens und Entwickelns verankert zu werden und aus der Gruppe ausgewählt ist bestehend aus
i) Mattierungsmitteln, die ein Porenvolumen von ≥ 0,9 ml/g aufweisen;
ü) Mattierungsmitteln, die einen BET- (Brunauer-Emmctt-Teller-) Oberflächenbereich von ≥ 150 m²/g aufweisen;
iii) Mattierungsmitteln, die eine Ölzahl von ≥ 150 g/100 g aufweisen;
iv) Mattierungsmitteln, die mindestens eine vernetzbare Gruppe aufweisen; und
v) Kombinationen derselben.

2. Photoempfindliches Element nach Anspruch 1, wobei das Mattierungsmittel in der Lage ist, während des Kontaktierens der mattierten Schicht mit der photopolymerisierbaren Schicht und dem Aussetzen des photoempfindlichen Elements durch aktinische Strahlung verankert zu werden.

3. Photoempfindliches Element nach Anspruch 1, wobei die mattierte Schicht ≥ 10 Gew,-% des Mattierungsmittels umfasst.

4. Photoempfindliches Element nach Anspruch 1, wobei die mattierte Schicht ≥ 15 Gew.-% des Mattierungsmittels umfasst.

5. Photoempfindliches Element nach Anspruch 1, wobei das Mattierungsmittel ein Porenvolumen von 1,0 - 2,5 ml/g aufweist.

6. Photoempfindliches Element nach Anspruch 1, wobei das Mattierungsmittel eine BET-Oberfläche von ≥ 200 m²/g aufweist.

7. Photoempfindliches Element nach Anspruch 1, wobei das Mattierungsmittel eine Ölzahl von ≥ 200 g/100 g aufweist.

8. Photoempfindliches Element nach Anspruch 1, wobei das Mattierungsmittel mit mindestens einer ethylenisch ungesättigten Verbindung, die durch aktinische Strahlung photopolymerisierbar ist, gefüllt und/oder beladen ist.

9. Photoempfindliches Element nach Anspruch 1, wobei das Mattierungsmittel, das mindestens einer vernetzbare Gruppe aufweist, mindestens eine ethylenisch ungesättigten Gruppe enthält, die durch aktinische Strahlung photopolymerisierbar ist.

10. Photo empfindliches Element nach Anspruch 1, wobei das Mattierungsmittel, das mindestens eine vernetzbare Gruppe aufweist, in der Lage ist, thermisch verankert zu werden.

11. Photoempfindliches Element nach Anspruch 1, wobei das Mattierungsmittel ein Mattierungsmittel mit einer mittleren Teilchengröße von ≥ 3 µm ist.

12. Photoempfindliches Element nach Anspruch 1, wobei das Mattierungsmittel ein Mattierungsmittel mit einer mittleren Teilchengröße von 3-15 µm ist.

13. Photoempfindliches Element nach Anspruch 1, wobei das Mattierungsmittel ein Mattierungsmittel mit einer mittleren Teilchengröße von ≥3 µm, einem Porenvolumen von ≥ 0,9 ml/g und einer Ölzahl von ≥ 150 g/100 g ist.

14. Photoempfindliches Element nach Anspruch 1, wobei das Mattierungsmittel ein Mattierungsmittel mit einer mittleren Teilchengröße von ≥ 3 µm, einem Porenvolumen von ≥ 0,9 ml/g, einer Ölzahl von ≥ 150 g/100 g und einer BET-Oberfläche von ≥ 150 m²/g ist.

15. Photoempfindliches Element nach Anspruch 1, wobei das Mattierungsmittel ein Mattierungsmittel mit einer mittleren Teilchengröße von ≥ 3 µm, einem Porenvolumen von 1,0 - 2,5 ml/g, einer Ölzahl von ≥ 200 g/100 g und einer BET-Oberfläche von ≥ 200 m²/g ist.

16. Photoempfindliches Element nach Anspruch 1, wobei das Mattierungsmittel ≤ 20 Gew.-% Teilchen mit einer Teilchengröße von ≥ 15 µm umfasst, wobei der Gewichtsprozentsatz auf die Gesamtmenge an Mattierungsmittel bezogen ist.

17. Photoempfindliches Element nach Anspruch 1, wobei das Mattierungsmittel ≥ 10 Gew.-% eines Mattierungsmittels mit einer Teilchengröße von ≤ 3 µm umfasst, wobei der Gewichtsprozentsatz auf die Gesamtmenge an Mattierungsmittel bezogen ist.

18. Photoempfindliches Element nach Anspruch 1, wobei das Mattierungsmittel ≤ 20 Gew.-% eines Mattierungsmittels umfasst, das nicht in der Lage ist, in der Oberfläche der photopolymerisierbaren Schicht verankert zu werden.

19. Photoempfindliches Element nach Anspruch 1, wobei die mattierte Schicht mindestens ein Mattierungsmittel ausgewählt aus der Gruppe bestehend aus Kieselsäuren, Silicaten und/oder Aluminaten umfasst.

20. Photoempfindliches Element nach Anspruch 1, wobei die mattierte Schicht mindestens ein polymeres Bindemittel ausgewählt aus der Gruppe bestehend aus Polyamiden, Copolymeren von Ethylen und Vinylacetat, Polyestern, Celluloseestern und Polyolefinen umfasst.

21. Photoempfindliches Element nach Anspruch 1, wobei die mattierte Schicht mindestens ein Pigment und/oder einen Farbstoff umfasst.

22. Photoempfindliches Element nach Anspruch 1, wobei die mattierte Schicht mindestens eine IR-empfindliche Verbindung umfasst.

23. Photoempfindliches Element nach Anspruch 1, des weiteren eine zusätzliche Schicht zwischen der mattierten Schicht und der elastomeren photopolymerisierbaren Schicht umfassend, wobei die zusätzliche Schicht aus der Gruppe ausgewählt ist bestehend aus einer elastomeren Schicht, die in der Lage ist, photoempfindlich zu werden, und einer Wachsschicht.

24. Photoempfindliches Element nach Anspruch 1, des Weiteren eine Deckplatte auf der mattierten Schicht der photopolymerisierbaren Schicht gegenüberliegend umfassend.

25. Photoempfindliches Element nach Anspruch 1, des Weiteren eine IR-empfindliche Schicht umfassend, die sich über der mattierten Schicht der photopolymerisierbaren Schicht gegenüberliegend befindet.

26. Verfahren für das Herstellen eines photoempfindlichen Elements umfassend
(a) das Bereitstellen einer elastomeren photopolymerisierbaren Schicht, die sich auf einem Träger befindet, wobei die photopolymerisierbare Schicht mindestens ein elastomeres Bindemittel, mindestens eine ethylenisch ungesättigte Verbindung, die durch aktinische Strahlung photopolymerisierbar ist, und mindestens einen Photoinitiator oder ein Photoinitiatorsystem enthält, wobei die elastomere photopolymerisierbare Schicht eine dem Träger gegenüberliegende Oberfläche aufweist;
(b) das Bereistellen einer mattierten Schicht, die ein polymeres Bindemittel und mindestens ein Mattierungsmittel umfasst, wobei das mindestens eine Mattierungsmittel in der Lage ist, in der Oberfläche der bildmäßig photopolymerisierten Bereiche der photopolymerisierbaren Schicht während des bildmäßigen Aussetzens und Entwickelns verankert zu werden und aus der Gruppe ausgewählt ist bestehend aus
i) aus Mattierungsmitteln, die ein Porenvolumen von ≥ 0,9 ml/g aufweisen;
ii) Mattierungsmitteln, die eine BET- (Brunauer-Emmett-Teller-) Oberfläche ≥ 150 m²/g aufweisen;
iii) Mattierungsmitteln, die eine Ölzahl von ≥ 150 g/100 g aufweisen;
iv) Mattierungsmitteln, die mindestens eine vernetzbare Gruppe aufweisen; und
v) Kombinationen derselben
und
(c) das Kontaktieren der mattierten Schicht mit der Oberfläche der elastomeren photopolymerisierbaren Schicht unter Bildung des photoempfindlichen Elements.

27. Verfahren nach Anspruch 26, wobei das photoempfindliche Element des Weiteren eine zusätzliche Schicht zwischen der mattierten Schicht und der elastomeren photopolymerisierbaren Schicht umfasst, wobei die zusätzliche Schicht aus der Gruppe ausgewählt ist bestehend aus einer elastomeren Schicht, die in der Lage ist, photoempfindlich zu werden, und einer Wachsschicht, wobei das Verfahren des Weiteren Folgendes umfasst:
das Bereitstellen einer zusätzlichen Schicht zum Element durch entweder
(d') Bereitstellen der zusätzlichen Schicht auf der Oberfläche der elastomeren photopolymerisierbaren Schicht und Kontaktieren der mattierten Schicht mit einer Oberfläche der zusätzlichen Schicht der Elastomeren photopolymerisierbaren Schicht gegenüberliegend, oder
(d") Bereitstellen der zusätzlichen Schicht auf der mattierten Schicht und das Kontaktieren der zusätzlichen Schicht mit der Oberfläche der elastomeren photopolymerisierbaren Schicht.

28. Verfahren nach Anspruch 26, wobei das Kontaktieren durch Laminieren der mattierten Schicht auf die Oberfläche der photopolymerisierbaren Schicht dem Träger gegenüberliegend erfolgt.

29. Verfahren nach Anspruch 26, wobei das Kontaktieren Folgendes umfasst:
(1) das Einführen in den Quetschspalt eines Kalanders einer Masse einer heißen photopolymerisierbaren Zusammensetzung umfassend mindestens ein elastomeres Polymer, mindestens eine ethylenisch ungesättigte Verbindung, die durch aktinische Strahlung photopolymerisierbar ist, und mindestens einen Photoinitiator oder Photoinitiatorsystem und
(2) im heißen Zustand das Kalandrieren der photopolymerisierbaren Zusammensetzung zwischen dem Träger und einem Deckclement zum Bilden der photopolymerisierbaren Schicht dazwischen, wobei das Deckelement eine Deckplatte und die mattierte Schicht umfasst, wobei die mattierte Schicht an der photopolymerisierbaren Schicht anliegt.

30. Verfahren für das Herstellen einer Flexodruckplatte umfassend
(A) das Aussetzen eines photoempfindlichen Elements einer durch eine Photomaske gehenden aktinische Strahlung, wobei das photoempfindliche Elements umfasst:
a) einen Träger,
(b) mindestens eine elastomere photopolymerisierbare Schicht auf dem Träger, der mindestens ein elastomeres Bindemittel, mindestens eine ethylenisch ungesättigte Verbindung, die durch aktinische Strahlung photopolymerisierbar ist, und mindestens einen Photoinitiator oder ein Photoinitiatorsystem enthält, und
c) eine mattierte Schicht, die sich über einer Oberfläche der photopolymerisierbaren Schicht dem Träger gegenüberliegend befindet, umfassend ein polymeres Bindemittel und mindestens ein Mattierungsmittel, wobei das mindestens eine Mattierungsmittel in der Lage ist, in der Oberfläche der bildmäßig photopolymerisierten Bereiche der photopolymerisierbaren Schicht während des bildmäßigen Aussetzens und Entwickelns verankert zu werden und aus der Gruppe ausgewählt ist bestehend aus
i) Mattierungsmitteln, die ein Porenvolumen von ≥ 0,9 ml/g aufweisen;
ii) Mattierungsmitteln, die einen BET- (Brunauer-Emmett-Teller-) Oberflächenbereich von ≥ 150 m²/g aufweisen;
iii) Mattierungsmitteln, die eine Ölzahl von ≥ 150 g/100 g aufweisen;
iv) Mattierungsmitteln, die mindestens eine vernetzbare Gruppe aufweisen; und
v) Kombinationen derselben,
unter Bildung der polymerisierten Bereiche und unpolymerisierten Bereiche in der photopolymerisierbaren Schicht;
(B) das Entfernen der Photomaske,
(C) das Behandeln des ausgesetzten photoempimdlichen Elements zum Entfernen unpolymerisierter Bereiche und zum Bilden einer Relieffläche, die für das Bedrucken geeignet ist

31. Verfahren nach Anspruch 30, wobei der Behandlungsschritt (C) aus der Gruppe ausgewählt ist bestehend aus
(1) aus dem Entwickeln mit mindestens einer Auswaschlösung ausgewählt aus der Gruppe bestehend aus Lösungsmittellösung, wässriger Lösung, halbwässriger Lösung und Wasser und
(2) dem Erhitzen des Elements auf eine Temperatur, die ausreicht, um die unpolymerisierten Teile zum Schmelzen, Fließen oder Erweichen zu bringen und dem Kontaktieren des Elements mit einem absorptionsfähigen Material zum Entfernen der unpolymerisienen Teile.

32. Verfahren nach Anspruch 30, wobei der Aussetzungsschritt (A) in einem Vakuum stattfindet.

33. Verfahren nach Anspruch 30, wobei der Aussetzungsschritt (A) in Abwesenheit von Luftsauerstoff stattfindet.

34. Verfahren nach Anspruch 30, wobei der Entfernungsschritt (B) während des Behandlungsschritts (C) stattfindet.

35. Photoempfindliches Element nach Anspruch 2, wobei der Aussetzungsschritt in einem Vakuum (C) stattfindet.

36. Flexodruckplatte hergestellt durch das Verfahren nach Anspruch 30.

37. Flexodruckplatte nach Anspruch 36, wobei die Oberfläche der Flexodruckplatte Teilchen des Mattierungsmittels umfasst.

38. Flexodruckplatte nach Anspruch 36, wobei ≥ 0,5 % der Oberfläche der Flexodruckplatte mit dem Mattierungsmittel bedeckt ist.

39. Flexodruckplatte nach Anspruch 36, wobei ≥ 1 % der Oberfläche der Flexodruckplatte mit dem Mattierungsmittel bedeckt ist.

40. Flexodruckplatte nach Anspruch 36, wobei ≥ 10 % der Oberfläche der Flexodruckplatte mit dem Mattierungsmittel bedeckt ist.

## Revendications

1. Élément photosensible pour une utilisation comme plaque d'impression flexographique, comprenant :
a) un support ;
b) au moins une couche photopolymérisable élastomère sur le support contenant au moins un liant élastomère, au moins un composé insaturé en éthylène, photopolymérisable par radiation actinique, et au moins un photoamorceur ou système photoamorceur ; et
c) une couche matée disposée au-dessus d'une surface de 1a couche photopolymérisable à l'opposé du support comprenant un liant polymère et au moins un agent de matité, ledit au moins un agent de matité pouvant être ancré dans la surface de zones photopolymérisées image par image de la couche photopolymérisable pendant l'exposition et le développement image par image et étant sélectionné dans le groupe composé des
i) agents de matité ayant un volume de pores de ≥ 0,9 ml/g ;
ii) agents de matité ayant une surface BET (Brunauer Emmett Teller) de ≥ 150 m²/g ;
iii) agents de matité ayant un indice d'absorption d'huile de ≥ 150 g/100 g ;
iv) agents de matité comportant au moins un groupe réticulable ; et
v) de combinaisons de ceux-ci.

2. Élément photosensible selon la revendication 1, dans lequel l'agent de matité peut être ancré pendant la mise en contact de la couche matée avec la couche photopolymérisable et l'exposition de l'élément photosensible à la radiation actinique.

3. Élément photosensible selon la revendication 1, dans lequel la couche matée comprend ≥ 10% en poids de l'agent de matité.

4. Élément photosensible selon la revendication 1, dans lequel la couche matée comprend ≥ 15% en poids de l'agent de matité.

5. Élément photosensible selon la revendication 1, dans lequel l'agent de matité présente un volume de pores de 1,0 à 2,5 ml/g.

6. Élément photosensible selon la revendication 1, dans lequel l'agent de matité présente une surface BET de ≥ 200 m²/g.

7. Élément photosensible selon la revendication 1, dans lequel l'agent de matité présente un indice d'absorption d'huile de ≥ 200 g/100 g.

8. Élément photosensible selon la revendication 1, dans lequel l'agent de matité est rempli et/ou chargé avec au moins un composé insaturé en éthylène, photopolymérisable par radiation actinique.

9. Élément photosensible selon la revendication 1, dans lequel l'agent de matité comportant au moins un groupe réticulable contient au moins un groupe insaturé en éthylène, photopolymérisable par radiation actinique.

10. Élément photosensible selon la revendication 1, dans lequel l'agent de matité comportant au moins un groupe réticulable peut être ancré de façon thermique.

11. Élément photosensible selon la revendication 1, dans lequel l'agent de matité est un agent de matité avec une taille de particule moyenne de ≥ 3 µm.

12. Élément photosensible selon la revendication 1, dans lequel l'agent de matité est un agent de matité avec une taille de particule moyenne de 3 à 15 µm.

13. Élément photosensible selon la revendication 1, dans lequel l'agent de matité est un agent de matité avec une taille de particule moyenne de ≥ 3 µm, un volume de pores de ≥ 0,9 ml/g et un indice d'absorption d'huile de ≥ 150 g/100 g.

14. Élément photosensible selon la revendication 1, dans lequel l'agent de matité est un agent de matité avec une taille de particule moyenne de ≥ 3 µm, un volume de pores de ≥ 0,9 ml/g, un indice d'absorption d'huile de ≥ 150 g/100 g et une surface BET de ≥ 150 m²/g.

15. Élément photosensible selon la revendication 1, dans lequel l'agent de matité est un agent de matité avec une taille de particule moyenne de ≥ 3 µm, un volume de pores de 1,0 à 2,5 ml/g, un indice d'absorption d'huile de ≥ 200 g/100 g, et une surface BET de ≥ 200 m²/g.

16. Élément photosensible selon la revendication 1, dans lequel l'agent de matité comprend ≤ 20% en poids de particules avec une taille de particule de ≥ 15 µm, le pourcentage de poids étant basé sur la quantité totale de l'agent de matité.

17. Élément photosensible selon la revendication 1, dans lequel l'agent de matité comprend ≥ 10% en poids d'un agent de matité avec une taille de particule de ≤ 3 µm, le pourcentage de poids étant basé sur la quantité totale de l'agent de matité.

18. Élément photosensible selon la revendication 1, dans lequel l'agent de matité comprend ≤ 20% en poids d'un agent de matité ne pouvant pas être ancré dans la surface de la couche photopolymérisable.

19. Élément photosensible selon la revendication 1, dans lequel la couche matée comprend au moins un agent de matité sélectionné dans le groupe composé des acides siliciques, des silicates et/ou des aluminates.

20. Élément photosensible selon la revendication 1, dans lequel la couche matée comprend au moins un liant polymère sélectionné dans le groupe composé des polyamides, des copolymères d'éthylène et d'acétate de vinyle, des polyesters, des esters de cellulose et des polyoléfines.

21. Élément photosensible selon la revendication 1, dans lequel la couche matée comprend au moins un pigment et/ou un colorant.

22. Élément photosensible selon la revendication 1, dans lequel la couche matée comprend au moins un composé sensible IR.

23. Élément photosensible selon la revendication 1, comprenant en outre une couche supplémentaire entre la couche matée et la couche photopolymérisable élastomère, la couche supplémentaire étant sélectionnée dans le groupe composé d'une couche élastomère capable de devenir photosensible et d'une couche de cire.

24. Élément photosensible selon la revendication 1, comprenant en outre une feuille de couverture sur la couche matée à l'opposé de la couche photopolymérisable.

25. Élément photosensible selon la revendication 1, comprenant en outre une couche sensible IR disposée au-dessus de la couche matée à l'opposé de la couche photopolymérisable.

26. Procédé pour préparer un élément photosensible, comprenant les étapes suivantes :
(a) fourniture d'une couche photopolymérisable élastomère sur un support, dans lequel la couche photopolymérisable contient au moins un liant élastomère, au moins un composé insaturé en éthylène, photopolymérisable par radiation actinique, et au moins un photoamorceur ou système photoamorceur, la couche photopolymérisable élastomère présentant une surface à l'opposé du support ; et
(b) fourniture d'une couche matée comprenant un liant polymère et au moins un agent de matité, ledit au moins un agent de matité pouvant être ancré dans la surface de zones photopolymérisées image par image de la couche photopolymérisable pendant l'exposition et le développement image par image et étant sélectionné dans le groupe composé des
i) agents de matité ayant un volume de pores de ≥ 0,9 ml/g ;
ii) agents de matité ayant une surface BET (Brunauer Emmett Teller) de ≥ 150 m²/g ;
iii) agents de matité ayant un indice d'absorption d'huile de ≥ 150 g/100 g ;
iv) agents de matité comportant au moins un groupe réticulable ; et
v) de combinaisons de ceux-ci ;
et
(c) mise en contact de la couche matée avec la surface de la couche photopolymérisable élastomère formant l'élément photosensible.

27. Procédé selon la revendication 26, dans lequel l'élément photosensible comprend en outre une couche supplémentaire entre la couche matée et la couche photopolymérisable élastomère, la couche supplémentaire étant sélectionnée dans le groupe composé d'une couche élastomère pouvant devenir photosensible et d'une couche de cire, le procédé comprenant en outre :
la fourniture de la couche supplémentaire pour l'élément soit
(d') par fourniture de la couche supplémentaire sur la surface de la couche photopolymérisable élastomère, et mise en contact de la couche matée avec une surface de la couche supplémentaire à l'opposé de la couche photopolymérisable élastomère, soit
(d") par fourniture de la couche supplémentaire sur la couche matée et mise en contact de la couche supplémentaire avec la surface de la couche photopolymérisable élastomère.

28. Procédé selon la revendication 26, dans lequel la mise en contact se fait par laminage de la couche matée sur la surface de la couche photopolymérisable à l'opposé du support.

29. Procédé selon la revendication 26, dans lequel la mise en contact comprend les étapes suivantes :
(1) amenée dans la zone de contact d'une calandre d'une masse d'une composition photopolymérisable chaude comprenant au moins un polymère élastomère, au moins un composé insaturé en éthylène, photopolymérisable par radiation actinique, et au moins un photoamorceur ou système photoamorceur, et
(2) à l'état chaud, calandrage de la composition photopolymérisable entre le support et un élément de couverture pour former la couche photopolymérisable entre ceux-ci, dans lequel l'élément de couverture comprend une feuille de couverture et la couche matée, la couche matée étant adjacente à la couche photopolymérisable.

30. Procédé de préparation d'une plaque d'impression flexographique, comprenant les étapes suivantes :
(A) exposition à une radiation actinique à travers un masque de photogravure d'un élément photosensible comprenant
a) un support,
b) au moins une couche photopolymérisable élastomère sur le support contenant au moins un liant élastomère, au moins un composé insaturé en éthylène, photopolymérisable par radiation actinique, et au moins un photoamorceur ou système photoamorceur, et
c) une couche matée disposée au-dessus d'une surface de la couche photopolymérisable à l'opposé du support comprenant un liant polymère et au moins un agent de matité, ledit au moins un agent de matité pouvant être ancré dans la surface de zones photopolymérisées image par image de la couche photopolymérisable pendant l'exposition et le développement image par image et étant sélectionné dans le groupe composé des
i) agents de matité ayant un volume de pores de ≥ 0,9 ml/g ;
ii) agents de matité ayant une surface BET (Brunauer Emmett Teller) de ≥ 150 m²/g ;
iii) agents de matité ayant un indice d'absorption d'huile de ≥ 150 g/100 g ;
iv) agents de matité comportant au moins un groupe réticulable ; et
v) de combinaisons de ceux-ci,
en formant des zones polymérisées et des zones non polymérisées dans la couche photopolymérisable ;
(B) retrait du masque de photogravure,
(C) traitement de l'élément photosensible exposé pour retirer des zones non polymérisées et former une surface en relief adaptée pour l'impression.

31. Procédé selon la revendication 30, dans lequel l'étape de traitement (C) est sélectionnée dans le groupe composé des étapes suivantes
(1) développement avec au moins une solution de lessivage sélectionnée dans le groupe composé d'une solution de solvant, d'une solution aqueuse, d'une solution semi-aqueuse et d'eau ; et
(2) chauffage de l'élément jusqu'à une température suffisante pour amener les parties non polymérisées à fondre, couler ou ramollir, et mise en contact de l'élément avec un matériau absorbant pour retirer les parties non polymérisées.

32. Procédé selon la revendication 30 dans lequel l'étape d'exposition (A) a lieu sous vide.

33. Procédé selon la revendication 30 dans lequel l'étape d'exposition (A) a lieu en l'absence d'oxygène atmosphérique.

34. Procédé selon la revendication 30 dans lequel l'étape de retrait (B) a lieu pendant l'étape de traitement (C).

35. Élément photosensible selon la revendication 2, dans lequel l'exposition a lieu sous vide.

36. Plaque d'impression flexographique produite par le procédé selon la revendication 30.

37. Plaque d'impression flexographique selon la revendication 36, dans laquelle la surface de la plaque d'impression flexographique comprend des particules de l'agent de matité.

38. Plaque d'impression flexographique selon la revendication 36, dans laquelle ≥ 0,5% de la surface de la plaque d'impression flexographique est recouvert par l'agent de matité.

39. Plaque d'impression flexographique selon la revendication 36, dans laquelle ≥ 1% de la surface de la plaque d'impression flexographique est recouvert par l'agent de matité.

40. Plaque d'impression flexographique selon la revendication 36, dans laquelle ≥ 10% de la surface de la plaque d'impression flexographique sont recouverts par l'agent matité.
